(19) Europäisches Patentamt
European Patent Office
Office européen des brevets

(11) EP 1 700 710 B1

(12) # EUROPEAN PATENT SPECIFICATION

(45) Date of publication and mention of the grant of the patent:
**08.10.2008 Bulletin 2008/41**

(51) Int Cl.:
***B41N 6/00** (2006.01)* ***G03F 7/09** (2006.01)*

(21) Application number: **06110606.8**

(22) Date of filing: **02.03.2006**

(54) **Printing method and mounting method of printing plate**

Druckverfahren und Druckplattenbefestigungsverfahren

Procédé d'impression et procédé de fixation d'une plaque d'impression

(84) Designated Contracting States:
**DE FR GB IT**

(30) Priority: **08.03.2005 JP 2005063520**

(43) Date of publication of application:
**13.09.2006 Bulletin 2006/37**

(73) Proprietor: **Konica Minolta Medical & Graphic, Inc.
Hino-shi,
Tokyo 191-8511 (JP)**

(72) Inventor: **Sampei, Takeshi
Hachioji-shi,Tokyo 192-8505 (JP)**

(74) Representative: **Henkel, Feiler & Hänzel
Patentanwälte
Maximiliansplatz 21
80333 München (DE)**

(56) References cited:
**EP-A- 1 498 281**

- **PATENT ABSTRACTS OF JAPAN vol. 1998, no. 12, 31 October 1998 (1998-10-31) & JP 10 193828 A (MITSUBISHI PAPER MILLS LTD), 28 July 1998 (1998-07-28)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 700 710 B1

## Description

### BACKGROUND OF THE INVENTION

The present invention relates to a printing method of a printing plate material employing plastic as a support, and a mounting method of the printing plate material, particularly, relates to a printing method of a printing plate capable of image formation by means of a computer-to-plate (CTP) method, and a mounting method of a printing plate material.
In recent years, computer-to-plate (CTP), in which image data is directly recorded on a printing plate, has been prevailing in accordance with digitalization of printing data. A printing plate material utilized in CTP includes such as one provided with a photosensitive layer based on a silver salt diffusion transfer method on a support (for example, refer to patent literature 1) and one in which the portion to form an image is fusing fixed on a hydrophilic substrate by being image-wise heated with such as laser exposure (for example, refer to patent literature 2).
Generally, a printing plate material utilized in CTP includes a type employing an aluminum support similar to a conventional PS plate and a flexible type provided with each functional layer for a printing plate on a film substrate, however, in recent years, technologies of a flexible type printing plate, which employs a plastic support for convenience of handling and carrying of a printing plate, are known (for example, refer to patent literatures 3, 4 and 5).
Among them, a printing method, which utilizes a lithographic plate material based on a silver salt diffusion transfer method, provided with a silver halide emulsion layer and a physical development nucleus layer, is prevailing due to easy application to CTP.
In these printing plates employing a polyester film support, there is a problem of distortion due to elongation at the time of being mounted on a printing machine, and to overcome this problem, a method in which a sheet to fix a printing plate is included between a printing plate and a plate drum of a printing machine has been known (for example, refer to patent literature 6).
However, in these conventional technologies, there was still a problem of variation of printed images due to shift of a printing plate on a plate drum of a printing machine from the start of printing, which is so-called insufficient printing position stability.
Further, there was a problem of insufficient printing capabilities such as ink receptivity on an image portion at the start of printing and printing durability, and particularly in a printing method utilizing a silver salt diffusion transfer method as described above, there was a problem of image quality deterioration. Therefore a printing method to overcome these problems has been strongly desired.

[Patent Literature 1] JP-A No. 5-66564 (hereinafter, JP-A refers to Japanese Patent Publication Open to Public Inspection)
[Patent Literature 2] JP-A No. 2001-96710
[Patent Literature 3] JP-A No. 5-257287
[Patent Literature 4] JP-A No. 2000-258899
[Patent Literature 5] JP-A No. 2002-79773
[Patent Literature 6] JP-A No. 10-193828

EP-A-1 498 281 discloses a printing method comprising the steps of mounting an underlay sheet on a plate cylinder of a printing press, and providing, on the underlay sheet, a printing plate material comprising a plastic sheet support, and provided thereon, a hydrophilic layer, an image formation layer and a backing layer, the backing layer being provided on the side of the support opposite the image formation layer, so that the backing layer side surface of the printing plate material contacts the underlay sheet surface, wherein a coefficient of dynamic friction of the backing layer side surface of the printing plate material to the underlay sheet surface is from 0.1 to 0.5.

### SUMMARY OF THE INVENTION

An object of this invention is to provide a printing method, and a mounting method of a printing plate material which can provide printing exhibiting excellent print position stability, as well as superior initial ink receptivity on the image portion, printing durability and image quality.
The above-described object of this invention can be achieved by the following means.
Item 1 A mounting method of mounting a printing plate material on a printing machine, comprising the steps of:

mounting an underlay sheet material on a plate drum of a printing machine; and
further mounting a printing plate material on the underlay sheet material;
wherein the printing plate material comprises a plastic support and has a hydrophilic layer and an image forming functional layer on one surface of the plastic support and a back-coat layer on the other side of the plastic support;

characterized in that the surface specific resistance of the back-coat layer side of said printing plate material is $1 \times 10^9 - 2 \times 10^{13}$ Ω and the surface specific resistance of the surface, which is in contact with the back-coat layer of the printing plate material, of said underlay sheet material is $1 \times 10^8 - 2 \times 10^{15}$ Ω, wherein the surface specific resistance is measured at 23°C and a relative humidity of 20%.

Item 2 The mounting method described in Item 1 wherein the thickness of the underlay sheet material is 30 - 250 μm.

Item 3 The mounting method described in Item 1 or 2,

wherein the aforesaid plastic support is a polyester film support having a thickness of 120 - 300 μm and a thickness distribution of 10% or less.

Item 4 The mounting method described in any one of Items 1 - 3, wherein a layer containing a silver halide emulsion is provided on the hydrophilic layer of the aforesaid printing plate material.

Item 5 A printing method which uses a printing plate material mounted on a plate drum of a printing machine as defined in any one of claims 1 to 4.

According to the above constitution of this invention, provided can be a printing method and a mounting method of a printing plate material which provide printing exhibiting excellent print position stability as well as superior initial ink receptivity on the image portion, printing durability and image quality.

## DETAILED DESCRIPTION OF THE PREFERRED EMBODIMENT

In this invention, a printing method in which printing is performed by including a sheet material between a printing plate material, which is provided with a hydrophilic layer and an image forming functional layer on the one surface of a plastic support and a back-coat layer on the other side, and a plate drum of a printing machine, is characterized in that the surface specific resistance of the back-coat layer side of said printing plate material is $1 \times 10^9 - 2 \times 10^{13}$ Ω, and the surface specific resistance of the surface, which is in contact with the printing plate material, of said sheet material is $1 \times 10^8 - 2 \times -10^{15}$ Ω.

In this invention, a printing method, which provide printing exhibiting excellent print position stability as well as superior initial ink receptivity on the image portion, printing durability and image quality, can be provided particularly by setting the surface specific resistance of the back-coat layer side of said printing plate material to $1 \times 10^9 - 2 \times 10^{13}$ Ω and the surface specific resistance of the surface, which is in contact with the printing plate material, of said sheet material to $1 \times 10^8 - 2 \times 10^{15}$ Ω.

(Sheet Material)

A sheet material used in this invention is provided with a surface specific resistance of the surface in contact with a printing plate material of $1 \times 10^8 - 2 \times 10^{15}$ Ω.

The above-descried surface in contact with a printing plate material is the surface opposite to the surface in contact with the plate drum when a sheet material is included between a plate drum of a printing machine and the printing plate material, and the surface in contact with a back-coat layer of a printing plate material.

As a sheet material, those provided with a surface layer on a substrate are preferably utilized.

A substrate utilized includes such as a metal plate, a resin sheet and a metal-resin complex sheet, and more preferably a metal plate such as an aluminum plate, a zinc plate, a titanium plate and a stainless steel plate; a bimetal plate such as a copper-aluminum plate, a copper-stainless steel plate and a chromium-copper plate; a tri-metal plate such as a chromium-copper-aluminum plate, a chromium-lead-iron plate and a chromium-copper-stainless steel plate; a resin sheet such as a PET sheet, a PE sheet, a PP sheet, a polyester sheet, a polyimide sheet, a polyamide sheet and an acrylic resin sheet; and a metal-resin complex sheet such as an aluminum-PET sheet, an aluminum-PE sheet, an aluminum-polyester sheet, a titanium PET sheet and a titanium PE sheet; and furthermore preferably includes a resin sheet such as a PET sheet and a PE sheet.

A substrate is preferably one having a sheet form provided with an initial modulus of elasticity of not less than 3400 $N/mm^2$. Thereby, roughness of a sheet material does not sink by printing pressure to function effectively.

Thickness of a substrate is suitably set to approximately 30 - 250 μm. The measurement of initial modulus of elasticity can be performed according to JIS K7127.

In this invention, a substrate utilized for a sheet material is preferably provided with a thickness distribution of 0 - 10% and is specifically preferably plastic film having a thickness distribution of 0 - 10%.

That is, a preferable embodiment is a sheet material characterized in that the sheet material described in aforesaid Item 1 is provided with a substrate having a thickness distribution of 0 - 10 %.

Herein, a measurement method of thickness distribution of a substrate is as follows: Lines are drawn in a grid form at each horizontal and vertical interval of 10 cm on a support having been cut into a square having an edge length of 60 cm; thicknesses at the 25 points being measured to determine the average, the maximum and the minimum; and the value, which is expressed in a percentage, of the difference of the maximum and the minimum divided by the average

is designated as thickness distribution.

In this invention, surface specific resistance of the surface, which contacts with a printing plate material, of a sheet material is necessarily 1 x $10^8$ - 2 x $10^{15}$ Ω (at 23°C and a relative humidity of 20%), preferably 1 x $10^8$ - 1 x $10^{13}$ Ω and more preferably 1 x $10^8$ - 1 x $10^{11}$ Ω.

Herein, to measure at 23 °C and a relative humidity of 20% means to measure the value immediately after the sample has been kept at 23 °C and a relative humidity of 23% for 24 hours.

To measure the value immediately after the sample has been kept at 23 °C and a relative humidity of 23% for 24 hours means to leave, for example, a printing plate material in a room conditioned at 23 °C and a relative humidity of 20% for 24 hours and to immediately measure surface specific resistance by use of a measurement apparatus of surface specific resistance (such as Teraohm Meter Model VE-30, produced by Kawaguchi Electric Works Co., Ltd.) in that room.

In this invention, it is possible to achieve adjustment of the surface specific resistance into the above-described region by utilizing an appropriate combination of the following technological means.

(1) To provide a conductive layer as a surface layer on a substrate:

A conductive layer is a layer containing such as soluble salt (such as chloride and nitrate), an evaporated metal layer, an insoluble inorganic salt such as described in USP No. 3,428,451 and a conductive metal oxide or a conductive polymer compound containing ionic polymer such as described in USP Nos. 2,861,056 and 3,206,312, however, is preferably a layer containing a conductive metal oxide compound, conductive polymer or conductive carbon black, which are described below.

A conductive polymer is preferably water-soluble conductive polymer, which can be utilized in combination with such as hydrophobic polymer particles and a hardener.

Water-soluble polymer includes polymer provided with at least one conductive group selected from a sulfonic acid group, a sulfuric ester group, a quaternary ammonium group, a tertiary ammonium group and a carboxyl group. Conductive group is preferably required at least 5 weight% per one polymer molecule.

Water-soluble conductive polymer may contain a hydroxyl group, an amino group, an epoxy group, an aziridine group, an active methylene group, a sulfin group, an aldehyde group or a vinyl sulfone group. An average molecular weight of polymer is preferably 3,000 - 100,000 and more preferably 3,500 - 70,000. Specific examples of water-soluble conductive polymer include compounds described in paragraph Nos. 0030 - 0046 of JP-A No. 7-20596.

These polymers can be synthesized by polymerizing a monomer which is available on the market or prepared by a conventional method. The addition amount of these compounds is preferably 0.01 - 10 g/$m^2$ and specifically preferably 0.1 - 5 g/$m^2$.

These compounds, alone or by mixing with various hydrophilic binders or hydrophobic binders, can form a layer.

Hydrophilic binders, which are specifically preferably utilized, include gelatin or polyacrylamide, however, in addition to these, listed are colloidal albumin, cellulose acetate, cellulose nitrate, polyvinyl alcohol, hydrolyzed polyvinyl acetate and phthalized gelatin.

Hydrophobic binders include polymer having a molecular weight of not less than 20,000 - 1,000,000, and listed are styrene-butyl acrylate-acrylic acid three-component copolymer, butyl acrylate-acrylonitrile-acrylic acid three-component copolymer and methyl methacrylate-ethyl acrylate-acrylic acid three-component copolymer.

A conductive layer may contain hydrophobic polymer particles. Hydrophobic polymer particles, which can be contained in a conductive layer, are constituted of so-called latex which is essentially insoluble in water, and this hydrophobic polymer is not specifically limited and can be prepared by polymerizing monomers selected as an arbitrary combination from such as styrene, styrene derivatives, alkyl acrylate, alkyl methacrylate, olefin derivatives, halogenated ethylene derivatives, vinyl ester derivatives and acrylonitrile. It is specifically preferred that styrene derivatives, alkyl acrylate or alkyl methacrylate is contained at not less than 30% and more preferably at not less than 50%.

As a hardener utilized in a conductive layer, a hydroxyl group-containing epoxy hardener is preferable, however, a reaction product [CA] of polyglycidol and epihalohydrin is more preferable. This is considered as a mixture judging from the synthetic method, however, it is not important whether this is a mixture or not since the effects of this invention can be achieved by depressing the number of a hydroxyl group and an epoxy group. Therefore this may be either an isolated compound or a mixture. Specific examples include compounds of paragraph Nos. 0062 - 0073 in JP-A No. 7-20596.

Next, metal oxide as a conductive compound will be explained. Metal oxide is preferably a crystalline metal oxide particle; however, those such as including an oxygen defect or a small amount of a foreign atom, which forms a donor against the utilized metal oxide, are specifically preferable because of the high conductivity, and the latter, those including a small amount of a foreign atom, which forms a donor against the utilized metal oxide, are specifically preferred because of not giving capability variation.

As examples of metal oxide, such as $ZnO_2$, $TiO_2$, $SnO_2$, $Al_2O_3$, $In_2O_3$, $SiO_2$, MgO, BaO, $MoO_3$ and $V_2O_5$, and

complex oxides thereof are preferred, and $ZnO_2$, $TiO_2$ and $SnO_2$ are specifically preferred.

As examples containing a foreign atom, effective is addition of such as Sb to SnO, or addition of such as Nb and Ta to $TiO_2$. The addition amount of these foreign atom is preferably in a range of 0.01 - 30 mol% and specifically preferably in a range of 0.1 - 10 mol.

Metal oxide particles utilized in this invention is provided with conductivity, and the volume resistivity is preferably not more than $10^7$ Ωcm and specifically preferably not more than $10^5$ Ωcm. These oxides are described in JP-A Nos. 56-143431, 56-120519 and 58-62647.

Metal oxide particles are utilized by being dispersed or dissolved in a binder. Binders utilizable are not specifically limited provided having film forming capability.

To decrease the resistance of a conductive layer by more effectively utilizing metal oxide, the volume content of metal oxide in a conductive layer is preferably the higher the better; however, the volume percentage of the metal oxide is preferably in a range of 5 - 95% since binder of at least approximately 5% is required to provide the layer with a sufficient strength.

The using amount of metal oxide is preferably 0.005 - 3 g/cm$^2$ and more preferably 0.01 - 2 g/cm$^2$. Thereby antistatic property can be achieved.

Carbon black includes conductive carbon black such as acetylene black prepared by such as a continuous thermal decomposition method, in which an acetylene gas is introduced into a reaction furnace being heated in advance to cause thermal decomposition and to raise the furnace temperature followed by proceeding of automatic decomposition, lamp black which is soot formed by incomplete combustion of such as oil, tar and resin with undisturbed flames, in addition to high structure furnace black; one type alone or combinations of at least two types can be utilized; and particle size is preferably not more than 100 μm and specifically preferably 0.01 - 2 μm.

Thickness of a conductive layer is preferably 0.1 - 5 μm and specifically preferably 0.2 - 3 μm.

(2) To set center line average roughness Ra of the surface of a mechanical sheet material in contact with a printing plate material to not less than 0.25 μm.

A center line average roughness in this invention refers to center line average roughness Ra, which is measured with a sample, having been kept under a condition of 23 °C and a relative humidity of 48% for 24 hours, by means of three dimensional roughness measurement under the same condition, and is defined according to JIS-B-0601 of JIS surface roughness.

A center line (center surface) average roughness (Ra) according to three dimensional digital measurement refers to the value determined by the following equation and expressed in micrometer (μm); when measurement of height, with respect to M points in X direction and N points in Y direction to make a total of MN points, is performed at a specific sampling length; a roughness curved surface, setting the height of center surface to 0, is determined; and height Z, at a measurement point of k-th point in X direction and j-th point in Y direction, is $f(Z_{jk})$.

[Numerical Equation 1]

$$Ra = \frac{1}{MN} \sum_{k=1}^{M} \sum_{j=1}^{N} |f(Z_{jk})|$$

A measurement apparatus capable of measuring a center line (center surface) average roughness (Ra) according to a three dimensional digital measurement includes, for example, RSTPLUS non-contact three dimensional micro surface form measurement system, produced by Veeco Instruments.

In this invention, center line average roughness Ra of the surface, which is in contact with the back-coat layer side of a printing plate material, of a sheet material is preferably not less than 0.25 μm and preferably 0.25 - 3.0 μm. To make Ra of this range can be achieved by mechanically roughening the substrate of a sheet material or by including a matting agent in a constituent layer of a sheet material.

As a mechanical method to form roughness on the substrate of a sheet material, such as a method to form roughness on the surface by spraying particles is known. Further, as a matting agent which can be contained in a constituent layer of a sheet material preferably has a mean particle size of not less than 1 μm and less than 20 μm. A matting agent preferably utilized includes inorganic micro-particles having a new Mohs' hardness of not less than 5 and an organic matting agent. Inorganic micro-particles having a new Mohs' hardness of not less than 5 include such as metal oxide particles (such as silica, alumina, titania, zirconia, ion oxide and chromium oxide), metal carbide particles

(such as silica carbide), boron nitride particles and diamond particles. An organic matting agent includes, for example, starch described in such as USP No. 2,322,037, starch derivatives described in such as Belgian Patent No. 625,451 and British Patent No. 981,198, polyvinyl alcohol described in such as Examined Japanese Patent Application Publication No. 44-3643, polystyrene or polymethacrylate described in such as Swiss Patent No. 330,158, polyacrylonitrile described in such as USP No. 3,079,257, and polycarbonate described in USP No. 3,022,169. The addition amount of these matting agents is preferably not less than 0.1 g and less than 10 g per 1 $m^2$.

To mount (fix) a sheet material used in this invention on a plate drum, employed is a conventional method well known in the art. For example, listed is a method, in which an adhesive or a tacky agent such as a spray paste and a double coating tape is applied on the back surface of the support of a sheet material, or a method, in which the top and the end of a sheet material are hooked with a latch arranged on a plate drum. Further, a combination method thereof can be also utilized.

The layer thickness of a sheet material used in this invention is specifically preferably 30 - 250 $\mu$m. The definition of layer thickness is same as what described above.

A support of a printing plate material used in this invention is a plastic support and specifically preferable is a polyester film support having a thickness distribution of not more than 10%. In the following, a polyester film will be explained.

[Polyester Film Support]

A polyester film support utilized as a plastic support is preferably provided with a thickness distribution of not more than 10%, more preferably of not more than 8% and specifically preferably of not more than 6%.

In this invention, a measurement method of a thickness distribution is as follows: Lines are drawn in a grid form at each horizontal and vertical interval of 10 cm on a support having been cut into a square having an edge length of 60 cm; thicknesses at the 25 points being measured to determine the average, the maximum and the minimum; and the value, which is expressed in a percentage, of the difference of the maximum and the minimum divided by the average is designated as thickness distribution.

Polyester utilized in a polyester film support is not specifically limited, however, is provided with a dicarboxylic acid component and a diol component as a primary constituent component, and is polyester such as polyethylene terephthalate (hereinafter, may be abbreviated as PET) and polyethylene naphthalate (hereinafter, may be abbreviated as PEN). Polyester is preferably copolymer or blended polymer, which is provided with PET or a portion comprising PET as a primary constituent component at not less than 50 weight% of the total polyester.

PET is synthesized utilizing terephthalic acid and ethylene glycol as constituent components, and PEN utilizing naphthalene dicarboxylic acid and ethylene glycol. PET or PEN may be also synthesized by mixing dicarboxylic acid or diol which constitutes PET or PEN with suitable third components of one type or of at least two types, and suitable third components are compounds provided with a divalent ester forming functional group, which include terephthalic acid, isophthalic acid, phthalic acid, 2,6-naphthlene dicarboxylic acid, 2,7-naphthalene dicarboxylic acid, diphenylsulfone dicarboxylic acid, diphenyl ether dicarbxylic acid, diphenylethane dicarboxylic acid, cyclohexane dicarboxylic acid, diphenyl dicarboxylic acid, diphenyl thioether dicarboxylic acid, diphenyl ketone dicarboxylic acid and phenylindane dicarboxylic acid. Further, examples of glycol include such as propylene glycol, tetramethylene glycol, cyclohexane dimethanol, 2,2-bis(4-hydroxyphenyl) propane, 2,2-bis(4-hydroxyethoxyphenyl) propane, bis(4-hydroxyphenyl) sulfone, bisphenolfluorene dihydroxyethyl ether, diethylen glycol, neopentyl glycol, hydroquinone and cyclohexane diol. As the third component, polyfunctional carboxylic acid and polyhydric alcohol can be mixed, however, these can be mixed at approximately 0.001 - 5 weight% of the total polyester constituent component.

An intrinsic viscosity of polyester is preferably 0.5 - 0.8. Further, those having different intrinsic viscosities may be also utilized in combination.

The synthesis method of polyester is not specifically limited and it can be prepared by a conventional polymerization method of polyester well known in the art. For example, employed can be a direct esterification method in which a dicarboxylic acid component is subjected to a direct esterification reaction with a diol component to esterify one of the hydroxyl groups of diol onto dicarboxylic acid, and further polymerization of the other diol is performed by being heated under reduced pressure to evaporating remove the excess diol; or an ester exchange method in which by utilizing dialkyl ester (such as dimethylester) as a dicarboxylic acid component, which is subjected to an ester exchange reaction with a diol component to evaporating eliminate alkylalcohol (such as methanol), whereby one of the hydroxyl groups of diol is esterified onto dicarboxylic acid, and further polymerization is performed by evaporation removing the excess diol with heating under reduced pressure.

As a catalyst, employed can be an ester exchange catalyst, a polymerization reaction catalyst and a thermal stabilizer which are utilized in synthesis of ordinary polyester. An ester catalyst includes such as $Ca(OAc)_2.H_2O$, $Zn(OAc)_2 \cdot 2H_2O$, $Mn(OAc)_2 \cdot 4H_2O$ and $Mg(OAc)_2 \cdot 4H_2O$, and a polymerization reaction catalyst includes such as $Sb_2O_3$ and $GeO_2$. Further, a thermal stabilizer includes such as phosphoric acid, phosphrous acid, $PO(OH)(CH_3)_3$, $PO(OC_6H_5)_3$

and $P(OC_6H_5)_3$. Further, in each process of the synthesis, added may be such as an anti-staining agent, a crystal nucleus agent, a sliding agent, a stabilizer, an anti-brocking agent, a UV absorbent, a viscosity control agent, a transparentizing agent, an antistatic agent, a pH adjusting agent, dye and pigment.

The thickness of a polyester film support is preferably in a range of 120 - 300 μm with respect to printing adaptability and handling characteristics.

That is, in this invention, the case, in which a plastic support contains polyester film having a thickness of 120 - 300 μm and a thickness distribution of 0 - 10%, is a specifically preferable embodiment.

(Preparation Method of Support)

To adjust the mean layer thickness and the thickness distribution of a support used in this invention in the above-described range, in this invention, it is preferred that a film casting process as described below is performed.

A film casting means of a support is preferably as follows: thermoplastic resin, having been fused at a temperature between the melting point (Tm) and Tm + 50 °C, is filtered through a sintered filter, followed by being extruded through a T-die, and a non-stretched sheet is formed on a casting drum rehumidified at a temperature of (a glass transition temperature (Tg) - 50 °C) - Tg.

At this time, to control thickness distribution in the above-described range, such as an electrostatic applying method is preferably employed. A non-stretched sheet is longitudinally stretched by 2 - 4 times at a temperature of Tg - (Tg + 50 °C). Further, as another method to control the thickness distribution in the above-described range, the longitudinal stretching is preferably performed multi-stepwise. At this time, the temperature of fore-step stretching is preferably adjusted to be higher than that of post-step stretching by 1 - 30 °C and more preferably by 2 - 15 °C.

The magnification of fore-step stretching is preferably 0.25 - 0.7 times of that of post-step stretching and more preferably 0.3 - 0.5 times. Thereafter, the support is preferably stretched by 2.5 - 5 times in the lateral direction at a temperature range of Tg - (Tg + 50 °C) after having been kept for 5 - 60 seconds and more preferably for 10 - 40 seconds in a temperature range of (Tg - 30 °C) - Tg.

Thereafter, the support is thermally fixed in a state of being held with chucks at (Tm - 50 °C) - (Tm - 5 °C) for 5 - 120 seconds. At this time, it is also preferable to narrow the chuck interval by 0 - 10% in the lateral direction (thermal relaxation). Then, the support having been cooled is provided with knurlingof 10 - 100 μm (provided with a knurling height of 10 - 100 μm) at the edges and wound to prepare multi-axially stretched film.

(Thermal Treatment of Support)

In this invention, to stabilize dimension at printing and to prevent doubling at color printing, polyester film, which has been stretched and thermally fixed, is preferably subjected to a thermal treatment. The thermal treatment is suitably performed according to the means as described below after the film having been cooled and wound is thermally fixed and unwound in a separate process. As a thermal treatment method, such as a transport method in which film is held with pins or clips such as a tenter, a roll transport method by use of a plural number of roll groups, a method to transport film by such as air transport in which film is blown with air to be floated, a method utilizing radiation heat by such as an infrared heater, and a method in which film is brought in contact with a plural number of heated rolls, are utilized alone or in combination of plural methods, and in addition to these, such as a transport method in which film is hanged by the own weight and wound up at the lower position is preferably utilized alone or in combination.

Tension control in thermal treatment can be achieved by control of torque of a winding roll and/or an unwinding roll, and/or by arranging a dancer roll in a process to control the weight applied thereto. In the case of varying tension at the time of cooling during and/or after a thermal treatment, a desired tension state may be set by arranging a dancer roll before and after these processes and/or in these processes and controlling their weight. Further, vibrational variation of transport tension can be effectively performed by decreasing the span between thermal treatment rolls.

The thermal treatment is preferably performed at a low transport tension and for a long time period as possible, with respect to not disturbing proceeding of thermal shrinkage and minimization of dimension change at the successive thermal treatment. The treatment temperature is preferably in a range of (Tg of polyester film + 50) - (Tg + 150) °C; in said temperature range, the transport tension is preferably 5 Pa - 1 MPa, more preferably 5 Pa - 500 kPa and furthermore preferably 5 Pa - 200 kPa; and the treatment time is preferably 30 seconds - 30 minutes and more preferably 30 seconds - 15 minutes. By setting the condition to the above-described temperature range, transport tension range and treatment time, deterioration of flatness of a support due to partial difference of thermal shrinkage of a support at the time of a thermal treatment is never caused and generation of micro flaws due to such as abrasion with transport rolls can be depressed.

To obtain a desired rate of dimension variation, the thermal treatment is preferably performed at least once and can be performed not less than two times when necessary.

Polyester film having been thermally treated is wound up after being cooled to ordinary temperature from a

temperature around Tg, and at this time, film is preferably cooled at least at a rate of not less than -5 °C/s until the temperature goes down to ordinary temperature passing through Tg to prevent flatness deterioration due to cooling.

The thermal treatment is preferably performed after coating of an under-coat layer described above. For example, a thermal treatment is preferably performed in a separate process after film, having been in-line coated with an under-coat layer during extrusion - thermal fixing - cooling, is wound once. Further, after film has been wound up once and an under-coat layer has been coated and dried in a separate process, a thermal treatment may be performed in a state of keeping the under-coated polyester film continuously flat as it is. Further, a thermal treatment similar to the above may be also performed after various functional layers such as a back-coat layer, a conductive layer, a sliding layer and an under-coat layer have been coated and dried.

(Water Content of Support)

The water content of a support is preferably not more than 0.5 weight% with respect to good transportation in such as an exposing apparatus.

A water content of a support means D' which represented by the following equation.

$$D' \text{ (weight\%)} = (w'/W') \times 100$$

wherein, W' represents a weight of a support which is in a rehumidified equilibrium state under an environment of 25 °C and 60% relative humidity, and w' represents a water content of a support which is in a rehumidified equilibrium state under an environment of 25 °C and 60% relative humidity.

The water content of a support is preferably not more than 0.5 weight%, more preferably 0.01 - 0.5 weight% and specifically preferably 0.01 - 0.3 weight%.

A means to control the water content of a support to not more than 0.5 weight% includes such as; (1) a support is thermally treated at not lower than 100 °C immediately before coating solutions of an image forming functional layer and other layers are coated; (2) the relative humidity of the process, at which coating solutions of an image forming functional layer and other layers are coated, is controlled; (3) A support is thermally treated at not lower than 100 °C before being coated with coating solutions of an image forming functional layer and other layers, and stored while being covering with a moisture-tight sheet, then coating is performed immediately after unsealing. At least two of these means may be also applied in combination.

(Adhesion Enhancing Treatment and Under-coat Layer Coating on Support)

Plastic support is preferably subjected to an adhesion enhancing treatment or under-coat layer coating on the coating surface to improve adhesion with a coated layer. An adhesion enhancing treatment includes such as a corona discharge treatment, a flame treatment, a plasma treatment and an ultraviolet ray irradiation treatment.

As an under-coat layer, such as a layer containing gelatin and latex is preferably provided.

Further, as a plastic support used in this invention, polyester film support is preferably utilized, however, a complex support, in which polyester film is appropriately laminated with a material such as a metal plate (for example, iron, stainless steel and aluminum) or paper covered with polyethylene (referred to also as a complex substrate), can be also utilized. These complex substrates may be laminated before a coating layer is formed, after a coating layer is formed, or immediately before the support is mounted on a printing machine.

(Micro-particles)

Further, in the above-described support, micro-particles of 0.01 - 10 μm are preferably added at 1 - 1000 ppm.

Herein, micro-particles may be either an organic substance or an inorganic substance. For example, as an inorganic substance, utilized can be silica described in such as Swiss Patent No. 330,158, glass powder described in such as French Patent No. 1,296,959, carbonates of alkali earth metal or carbonate of such as cadmium and zinc described in British Patent No. 1,173,181. As an organic substance, utilized can be organic micro-particles such as starch described in such as USP No. 2,322,037, starch derivatives described in such as Belgian Patent No. 625,451 and British Patent No. 981,198, polyvinyl alcohol described in such as Examined Japanese Patent Application Publication No. 44-3643, polystyrene or polymethacrylate described in such as Swiss Patent No. 330,158, polyacrylonitrile described in such as USP No. 3,079,257, polycarbonate described in such as USP No. 3,022,169. The shape of micro-particles may be either regular or irregular.

In this invention, it is used a printing plate material which has a constitution provided with at least a hydrophilic

layer, an image forming functional layer and a back-coat layer and characterized by having a surface specific resistance of the back-coat layer side of 1 x $10^9$ - 2 x $10^{13}$ Ω (at 23 °C and a relative humidity of 20%).

Herein, measurement at 23 °C and a relative humidity of 20% means that a measurement is performed immediately after the sample has been kept at 23 °C and a relative humidity of 20% for 24 hours.

Measurement immediately after the sample has been kept at 23 °C and a relative humidity of 20% for 24 hours means that, for example, a printing plate material is kept in a room rehumidified at 23 °C and a relative humidity of 20% for 24 hours, and immediately thereafter in the room, measurement is performed with respect to said material by use of an apparatus to measure surface specific resistance (such as Teraohm Meter Model VE-30, produced by Kawaguchi Electric Works Co., Ltd.).

In this invention, adjusting the surface specific resistance into the above-described range can be achieved by appropriately selecting a plural number of technical means from the following. (1) A conductive layer is provided between a support and an image forming functional layer or on the back-coat layer side; (2) the total of dry layer thickness on the back-coat layer side is 1 - 8 μm; and (3) an organic matting agent is contained in at least one layer on the back-coat layer side.

In the following, the above-described each solving means will be detailed.

(1) A conductive layer is provided between a support and an image forming functional layer or on the back-coat layer side:

A conductive layer includes a layer containing soluble salt (such as chloride and nitrate), an evaporated metal layer, an insoluble inorganic salt such as described in USP No. 3,428,451 and a conductive metal oxide or a conductive polymer compound containing ionic polymer such as described in USP Nos. 2,861,056 and 3,206,312, however, among them preferable is a layer containing a conductive metal oxide compound or conductive polymer compound shown below. Preferable conductive substances are the following conductive metal oxides.

A conductive compound includes such as conductive polymer, metal oxide or conductive carbon black.

A conductive polymer is preferably water-soluble conductive polymer, which is provided with an antistatic function by utilizing in combination with such as hydrophobic polymer particles and a hardener. Water-soluble polymer includes polymer provided with at least one conductive group selected from a sulfonic acid group, a sulfuric ester group, a quaternary ammonium group, a tertiary ammonium group and a carboxyl group. In this case, the conductive group is preferably required at least 5 weight% per one polymer molecule. Water-soluble conductive polymer may contain a hydroxyl group, an amino group, an epoxy group, an aziridine group, an active methylene group, a sulfin group, an aldehyde group or a vinyl sulfone group. An average molecular weight of polymer is preferably 3,000 - 100,000 and more preferably 3,500 - 70,000. Specific examples of water-soluble conductive polymer include compounds described in paragraph Nos. 0030 - 0046 of JP-A No. 7-20596.

These conductive polymers can be synthesized by polymerizing a monomer which is available on the market or prepared by a conventional method. The addition amount of these conductive polymers is preferably 0.01 - 10 g/$m^2$ and specifically preferably 0.1 - 5 g/$m^2$. These conductive polymers, alone or by mixing with various hydrophilic binders or hydrophobic binders, can form a conductive layer. Hydrophilic binders, which are specifically preferably utilized, include gelatin or polyacrylamide, however, in addition to these, listed are colloidal albumin, cellulose acetate, cellulose nitrate, polyvinyl alcohol, hydrolyzed polyvinyl acetate and phthalized gelatin. Further, hydrophobic binders include polymer having a molecular weight of not less than 20,000 - 1,000,000, and listed are styrene-butyl acrylate-acrylic acid three-component copolymer, butyl acrylate-acrylonitrile-acrylic acid three-component copolymer and methyl methacrylate-ethyl acrylate-acrylic acid three-component copolymer.

Hydrophobic polymer particles, which are utilized in a conductive layer, are constituted of so-called latex which is essentially insoluble in water; this hydrophobic polymer is not specifically limited and can be prepared by polymerizing monomers selected as an arbitrary combination from such as styrene, styrene derivatives, alkyl acrylate, alkyl methacrylate, olefin derivatives, halogenated ethylene derivatives, vinyl ester derivatives and acrylonitrile. It is specifically preferred that styrene derivatives, alkyl acrylate or alkyl methacrylate is contained at not less than 30% and more preferably at not less than 50%.

To make hydrophobic polymer into a latex form, listed is an emulsion polymerization and a dispersion method, in which solvent is evaporation removed after polymer of a solid form having been dissolved in a low boiling point solvent to be emulsifying dispersed, and either method can be employed, however, an emulsion polymerization method is preferred with respect to preparation of latex having a small particle size as well as a more uniform particle size distribution. At this time, the molecular weight of hydrophobic polymer is at least 3,000. Specific examples of hydrophobic polymer include each compound described in paragraph Nos. [0052] -[0057] of JP-A No. 7-20596. The addition amount of hydrophobic polymer is preferably 0.01 - 10 g/$m^2$ and specifically preferably 0.1 - 5.0 g/$m^2$.

In an emulsion polymerization method, a surfactant can be utilized, and as a dispersant utilizable in a dispersion method, primarily a nonionic surfactant and specifically a polyalkylene oxide compound is preferably utilized. A polyalkylene oxide compound refers to a compound provided with a polyalkylene oxide chain having at least 3 and

at most 500 of polyalkylene oxide chains, and for example, can be synthesized by condensation of polyalkylne oxide and compound having an active hydrogen atom such as fatty acid alcohol, phenols, fatty acid, aliphatic mercaptan and organic amine, or by condensation of polyol with such as aliphatic mercaptan, organic amine, ethylene oxide and propylene oxide. The above-described polyalkylene oxide compound may be a block copolymer in which a polyalkylene oxide chain in a molecule is divided in at least two portions. In this case, the total polymerization degree of polyethylene oxide is preferably not less than 3 and not more than 100. Specific examples of the above described polyalkylene oxide utilized in this invention, include such as compounds described in Japanese Patent No. 2805012.

As a hardener utilized in a conductive layer, a hydroxyl group-containing epoxy hardener is preferable, however, a reaction product [CA] of polyglycidol and epihalohydrin is more preferable. The above-described compound is considered as a mixture judging from the synthetic method, however, it is not important whether this is a mixture or not since the effects of this invention can be achieved by controlling the number of a hydroxyl group and an epoxy group. Therefore this may be either an isolated compound or a mixture. Specific examples include compounds shown in paragraph Nos. [0062] - [0073] of JP-A No. 7-20596.

Next, metal oxide as a conductive compound will be explained.

Metal oxide is preferably a crystalline metal oxide particle; however, those such as including an oxygen defect or a small amount of a foreign atom, which forms a donor against the utilized metal oxide, are specifically preferable because of the high conductivity, and the latter, those including a small amount of a foreign atom, which forms a donor against the utilized metal oxide, are specifically preferred because of not badly affecting against silver halide emulsion such as fog generation.

As examples of metal oxide, such as $ZnO_2$, $TiO_2$, $SnO_2$, $Al_2O_3$, $In_2O_3$, $SiO_2$, MgO, BaO, $MoO_3$ and $V_2O_5$ and complex oxides thereof are preferred, and $ZnO_2$, $TiO_2$ and $SnO_2$ are specifically preferred. As examples containing a foreign atom, addition of such as Sb to SnO or addition of such as Nb and Ta to $TiO_2$ is effective. The addition amount of these foreign atom is preferably in a range of 0.01 - 30 mol% and specifically preferably in a range of 0.1 - 10 mol.

Metal oxide particles utilized in this invention is provided with conductivity, and the volume resistivity is preferably not more than $1 \times 10^7$ Ωcm and specifically preferably not more than $1 \times 10^5$ Ωcm. Specific examples of the oxide are described in JP-A Nos. 56-143431, 56-120519 and 58-62647. Metal oxide particles are utilized by being dispersed or dissolved in a binder. Binders utilizable are not specifically limited provided having film forming capability.

To decrease the resistance of a conductive layer by more effectively utilizing metal oxide, the volume content of metal oxide in a conductive layer is preferably the higher the better; however, the volume percentage of the metal oxide is preferably in a range of 5 - 95% since binder of at least approximately 5% is required to provide the layer with a sufficient strength. The addition amount of metal oxide is preferably 0.05 - 1 g/cm$^2$ and more preferably 0.01 - 5.0 g/cm$^2$. Thereby desired antistatic property can be achieved.

Carbon black utilizable in this invention includes conductive carbon black such as acetylene black prepared by such as a continuous thermal decomposition method, in which an acetylene gas is introduced into a reaction furnace being heated in advance to cause thermal decomposition and to raise the furnace temperature followed by proceeding of automatic decomposition, lamp black which is soot formed by incomplete combustion of such as oil, tar and resin with undisturbed flames, in addition to high structure furnace black; one type alone or combinations of at least two types may be utilized; particle size is preferably not more than 100 μm and specifically preferably 0.01 - 2 μm. When the particle size is over 100 μm, carbon black may contaminate a coated product at manufacturing of the material and not achieve sufficient dispersibility to become unable to be uniformly incorporated, which deteriorates the value of a product. Herein, conductive carbon black usable in this invention is black colored so that it is also provided with an anti-halation effect.

Among each compound described above, as a conductive compound, conductive polymer or metal oxide is preferred. A layer containing a conductive compound is preferably provided between a support and an image forming functional layer or on the surface having a back-coat layer, however, a conductive layer is specifically preferably coated on the surface having a back-coat layer.

(2) The total dry layer thickness of the back-coat layer side is made to be preferably 1 - 8 μm:

In this invention, at least one layer of a back-coat layer is provided on the surface opposite to the surface having an image forming functional layer.

A back-coat layer used in this invention may be either a layer provided with an anti-reflection function or a conductive layer containing the aforesaid conductive compound, and further at least one of other functional layers may be also provided on the conductive layer.

As a preferable embodiment of this invention, a conductive layer and at least one protective layer are provided and the total dry layer thickness of the surface having a back-coat layer is preferably 1 - 8 μm.

(3) An organic matting agent is contained in at least one layer on the back-coat layer side:

In this invention, it is preferable to contain a matting agent in any one layer on the back-coat layer side. Among them, a matting agent is specifically preferably added in the outermost layer on the back-coat layer side. As an

organic matting agent, an organic polymer matting agent comprising organic polymer is preferred. Polymer utilized in the organic matting agent is selected from such as acrylic resin, vinyl chloride resin, vinyl acetate resin, styrol resin, vinylidene chloride resin, acetal resin and cellulose resin. These resins are preferably utilized in a state of being dispersed in water or in water-soluble polymer such as gelatin and acrylamide at a particle size of 0.5 - 20 μm and preferably 1 - 10 μm.

In the following, specific examples of polymer utilized in an organic matting agent are shown; however, this invention is not limited thereto.

(1) Acrylic resin: polymethyl methacrylate, polyethyl methacrylate, propyl methacrylate, dimethylaminoethyl methacrylate, methyl acrylate, ethyl acrylate, methoxyethyl acrylate;
(2) Copolymer acrylic resin: copolymer resin of monomer of resin listed in (1) with vinyl chloride, vinylidene chloride, vinyl pyridine, styrene, acrylonitrile, acrylic acid or methacrylic acid;
(3) Vinyl chloride resin: polyvinyl chloride; copolymer resin of vinyl chloride with vinyl acetate, vinylidene chloride, acrylic acid, methacrylic acid, maleic acid, maleic acid ester or acrylonitrile;
(4) Polyvinyl acetate and partially saponificated resin thereof;
(5) Styrol resin: polystyrene, copolymer resin of styrene with acrylonitrile;
(6) Polyvinylidene chloride resin: polyvinylidene chloride, copolymer resin of polyvinylidene chloride with acrylonitrile;
(7) Acetal resin: polyvinyl formal, polyvinyl butyral;
(8) Cellulose resin: cellulose acetate, cellulose propionate, cellulose butyrate, cellulose nitrate;
(9) Melamine resin: melamine-formaldehyde condensation resin, benzoguanamine·melamine·formaldehyde condensation resin.

Dispersion of these organic matting agents can be prepared by a method in which polymer is dissolved in a organic solvent and dispersed by being mixed with water or a gelatin aqueous solution while vigorous stirring; a method in which monomer is precipitated in a particle form while being polymerized by emulsion polymerization, precipitation polymerization or pearl polymerization; or by dispersing micro-particles of a matting agent in water or a gelatin aqueous solution by use of such as a stirrer, a homogenizer, a colloidal mill, a flow jet mixer and an ultrasonic homogenizer.

A mean particle size of an organic matting agent is preferably 0.5 - 10 μm, more preferably 0.7 - 7 μm and furthermore preferably 1 - 5 μm. Herein, a mean particle size of an organic matting agent can be determined by calculating a diameter of an equivalent circle from a projection area by use of an electronmicroscope. The coating amount of an organic matting agent in an addition layer is preferably 0.01 - 1 g/$m^2$ and specifically preferably 0.05 - 0.5 g/$m^2$. The above-described organic matting agent is coated by being incorporated in a hydrophilic binder or a hydrophobic binder. A hydrophilic binder utilized in this invention is not specifically limited provided having a hydrophilic property, and includes polyvinyl alcohol (PVA), cellulose type resin (such as methyl cellulose (MC), hydroxyethyl cellulose (HEC) and carboxymethyl cellulose (CMC)), chitins and starch which are resin provided with a hydroxyl group; polyethylene oxide (PEO), polypropylene oxide (PPO), polyethylene glycol (PEG) and polyvinyl ether (PVE) which are resin provided with an ether bond; and polyacrylamide (PAAM) and polyvinyl pyrrolidone (PVP) which are resin provided with an amide group or an amide bond. Further, also listed are polyacrylate, maleic acid resin, arginate and gelatins which are provided with a carboxyl group as a dissociating group; polystyrene sulfonate provided with a sulfone group; and polyallyl amine (PAA), polyethylene imine (PEI), epoxidized polyamide (EPAm), polyvinyl pyridine and gelatins which are provided with an amino group, an imino group, a tertiary ammonium group and a quaternary ammonium group.

A hydrophobic binder is not specifically limited provided being hydrophobic as a binder, and includes polymer arising from an α,β-ethylenic unsaturated compound such as polyvinyl chloride, chlorinated polyvinyl chloride, copolymer of vinyl chloride with vinylidene chloride, colpolymer of vinyl chloride with vinyl acetate, polyvinyl acetate and partially hydrolyzed polyvinyl acetate, polyvinyl acetal which is prepared from polyvinyl alcohol as a starting material and only a part of a repeating polyvinyl alcohol unit has reacted with aldehyde, preferably polyvinyl butyral, copolymer of acrylonitrile with acryl amide, polyacrylic acid ester, polymethacrylic acid ester, polystyrene and polyethylene; and mixtures thereof.

Further, a hydrophobic binder may be also one prepared from water dispersion type resin (polymer latex) described in paragraphs 0033 - 0038 of JP-A No. 2002-258469, when the surface of a finished printing plate material is hydrophobic.

Further, when an organic matting agent is added in a back-coat layer, effects such as to improve mounting easiness of the plate material onto a plate drum of a printing machine and to prevent image defects during aging storage are obtained.

A printing plate material used in this invention is provided with an image forming functional layer, which enables to become printable after exposure or after exposure and development, on a plastic support.

A printing plate material of an abrasion type as described in Japanese Translation of PCT Intrnational Application Publication No. 8-507727 and JP-A No. 6-186750, printing plate materials of a thermal adhesion image forming layer

on-press development type and a thermal fusing diffusion transfer type as described in JP-A Nos. 9-123387 and 2002-361996, and a printing plate utilizing a silver salt diffusion transfer method as described in JP-A No. 4-261539 are preferred.

Among them, a constitution used in this invention is preferably a lithographic plate utilizing a silver salt diffusion transfer method which contains silver halide emulsion in at least one layer on the image forming functional layer side.

That is, in this invention, a printing plate material is effective in the case of being provided with a silver halide emulsion layer as an image forming functional layer.

A layer having a silver halide emulsion is provided with a photographic emulsion comprising silver halide, and as a halogen composition of silver halide utilized therein may be any of silver chloride, silver bromochloride, silver bromoiodochloride, silver bromide, silver iodobromide and silver iodide, however, silver chloride, silver bromochloride and silver iodobromochloride which contains not less than 50 mol% of silver chloride are preferably utilized.

Photographic emulsion can be prepared according to a method described in such as Chimie et Physique Photographique (published by Paul Montel Corp. in 1967) by P. Glafkides, Photographic Emulsion Chemistry (published by The Focal Press in 1966) by G. F. Duffin, and Making and Coating Photographic Emulsion (published by The Focal Press in 1964) by V. L. Zelikman et al. That is, any of an acid method, a neutral method and an ammonia method can be employed, and any of a single-jet method, a double-jet method or a combination thereof can be employed as a form to react soluble silver salt and soluble halogenide.

Silver halide emulsion preferably contains an ion or a complex ion of metal belonging to 6 - 10th groups of the periodic table to depress illuminance reciprocity law failure and to adjust gradation. As the above metal, preferable are W, Fe, Co, Ni, Cu, Ru, Rh, Pd, Re, Os, Ir Pt and Au.

These metals can be introduced into silver halide as a form of a complex. In this invention, a transition metal complex is preferably a 6-dentate complex or complex ion represented by the following general formula.

General formula $[ML_6]^m$

wherein, M represents transition metal selected from elements of 6 - 10th group of the periodic table, L represents a cross-linking ligand and m represent 0, -, 2- or 3-.

Specific examples of ligands represented by L include such as each ligand of halogenide (fluoride, chloride, bromide and iodide), cyanide, cyanato, thiocyanato, selenocyanato, telluocyanato, azido and aquo; nitrosyl and thionitrosyl, and preferable are such as aquo, nitrosyl and thionitrosyl. In the case that an aquo ligand is present, it preferably occupies one or two of the ligands. L's may be same or different. Specifically preferable examples of M are rhodium (Rh), ruthenium (Ru), rhenium (Re), iridium (Ir) and osmium (Os). In the following, specific examples of transition metal ligand complexes will be shown.

1: $[RhCl_6]^{3-}$

2: $[RuCl_6]^{3-}$

3: $[ReCl_6]^{3-}$

4: $[RuBr_6]^{3-}$

5: $[OsCl_6]^{3-}$

6: $[IrCl_6]^{2-}$

7: $[Ru(NO)Cl_5]^{2-}$

8: $[RuBr_4(H_2O)]^{2-}$

9: $[Ru (NO) (H_2O) Cl_4]^{-}$

10: $[RhCl_5(H_2O)]^{2-}$

11: $[Re(NO)Cl_5]^{2-}$

12: $[Re(NO)(CN)_5]^{2-}$

13: $[Re(NO)Cl(CN)_4]^{2-}$

14: $[Rh(NO)_2Cl_4]^-$

15: $[Rh(NO)(H_2O)Cl_4]^-$

16: $[Ru(NO)(CN)_5]^{2-}$

17: $[Fe(CN)_6]^{3-}$

18 : $[Rh(NS)Cl_5]^{2-}$

19: $[Os(NO)Cl_5]^{2-}$

20: $[Cr(NO)Cl_5]^{2-}$

21: $[Re(NO)Cl_5]$ -

22: $[Os(NS)Cl_4(TeCN)]^{2-}$

23 : $[Ru(NS)Cl_5]^{2-}$

24: $(Re(NS)Cl_4(SeCN)^{2-}$

25: $[Os(NS)Cl(SCN)4]^{2-}$

26: $[Ir(NO)Cl5]^{2-}$

27: $[Ir(NS)Cl_5]^{2-}$

These metals or complex ions may be utilized alone or in combination of metals of the same type or of different types. The content of these metals or complex ions is generally 1 x $10^{-9}$ - 1 x $10^{-2}$ mol and preferably 1 x $10^{-8}$ - 1 x $10^{-4}$ mol, per 1 mol of silver halide.

A compound, which provides these metal ions or metal complex ions, is preferably incorporated into silver halide grains by being added at the time of silver halide grain formation, and may be added at any stage of before and after preparation of silver halide, that is nucleation, growth, physical ripening or chemical ripening, specifically preferably at a stage of nucleation, growth or physical ripening, furthermore preferably at a stage of nucleation or growth, and most preferably at the stage of nucleation. The addition may be performed by dividing into several times, and it is possible to incorporate the ion uniformly in a silver halide grain or to incorporate so as to provide distribution in the grain as described in JP-A Nos. 63-29603, 2-306236, 3-167545, 4-76534, 6-110146 and 5-273683.

It is preferable to provide distribution of the metal ion in the interior of the grain. These metal compounds can be added by dissolving in water or a suitable organic solvent (such as alcohols, ethers, glycols, ketones, esters and amides), and there may be employed, for example, a method in which an aqueous solution of powder of a metal compound or an aqueous solution, in which a metal compound together with NaCl and KCl has been dissolved, is added into a water-soluble silver salt solution or a water-soluble halide solution during the grain formation; a method in which a third aqueous solution of a metal compound is added, when a silver salt solution and a halide solution have been simultaneously mixed, to prepare silver halide grains by a simultaneous mixing of three solutions; a method in which a required amount of an aqueous solution of a metal compound is added into a reaction vessel during grain formation; or a method in which other silver halide grains, which have been doped with a metal ion or a metal complex ion in advance, are added to be dissolved at the time of silver halide grain preparation. Specifically preferable is a method in which an aqueous solution of powder of a metal compound or an aqueous solution, in which a metal compound together with NaCl and KCl have been dissolved, is added into a water-soluble halide solution. When a metal compound is added on the grain surface, it is also possible to charge a required amount of an aqueous solution of a metal compound into a reaction vessel immediately after grain formation, on the way of or at the finish of physical ripening, or at chemical ripening.

Photosensitive silver halide grains can be desalted by a washing method well known in the art such as a noodle method and a flocculation method.

Photosensitive silver halide grains are preferably subjected to chemical sensitization. As a preferable chemical sensitization, a sulfur sensitization method, a selenium sensitization method, a tellurium sensitization method, a noble

metal sensitization method, which employs such as gold compound, or platinum, palladium and iridium compounds, or a reduction sensitization method can be utilized as well known in the art. As preferable compounds utilized in a sulfur sensitization method, a selenium sensitization method and a tellurium sensitization method, compounds well known in the art can be utilized, however, compounds described in such as JP-A No. 7-128768 can be utilized. As preferable compounds utilized in a noble metal sensitization method, chloroauric acid, potassium chloroaurate, potassium aurithiocyanate, gold sulfide, gold selenide or compounds described in such as USP No. 2,448,060, British Patent No. 618,061 can be preferably utilized. As specific compounds for a reduction sensitization method, utilized can be such as stannous chloride, aminoiminomethane sulfinic acid, hydrazine derivatives, borane compounds, silane comounds and polyamine compounds in addition to ascorbic acid and thiourea dioxide. Further, reduction sensitization can be performed by ripening emulsion while keeping a pH of not lower than 7 and a pAg of not higher than 8.3. Further, reduction sensitization can be performed by introducing a single addition portion of a silver ion during grain formation.

Further, silver halide emulsion is preferably spectrally sensitized to desired wavelengths by sensitizing dye. Particularly, when a lithographic plate material is applied as a plate material utilized in CTP, the emulsion is preferably spectrally sensitized for a helium-neon laser, an argon laser, a LED and/or a semiconductor laser since the material is exposed by use of an apparatus equipped with a laser. Preferable sensitizing dye utilized in this invention includes compounds described in paragraph Nos. [0011] - [0204] of JP-A No. 2000-122297 for a helium-neon laser, a red LED and a red semiconductor laser, compounds described in paragraph Nos. [0014] - [0059] of JP-A No. 6-230577 for an infrared semiconductor laser, and compounds described in paragraph Nos. [0012] - [0023] of JP-A No. 2001-35026 for a blue semiconductor laser.

A binder of a silver halide emulsion layer is primarily constituted of gelatin, however, a part of which can be substituted by hydrophilic colloid such as described in the aforesaid hydrophilic layer constitution. The amount of gelatin in a silver halide emulsion layer is approximately 0.3 - 2 g/m$^2$ and preferably in a range of 0.5 -1.5 g/m$^2$. Silver halide emulsion layer is preferably hardened with a hardener. As a hardener for gelatin, compounds utilized as a hardener for a conventional photographic layer can be utilized; however, preferable are vinyl sulfone compounds. Further, a vinyl sulfone compound and other hardeners, for example, organic hardeners such as urea-formalin condensed compounds, melanin-formalin condensed compounds, an epoxy type compounds, aziridine type compounds, active olefins and isocyanate compounds; inorganic polyvalent metal salts of such as chromium, aluminum and zirconium; which are well known as a hardener for photographic emulsion, may be utilized in combination.

In manufacturing of a printing plate material used in this invention, another important factor is hardening of a photosensitive silver halide emulsion layer. The emulsion layer is preferably sufficiently hardened at least before printing.

A hardener may be added in a photographic emulsion coating solution similarly to a hardening method of a conventional photographic emulsion layer, or hardening may be performed by a method such as a thermal treatment before or after development and plate making. To obtain stable hardening characteristics, silver halide emulsion containing a hardener is appropriately heated after having been coated and dried. This heating treatment is a treatment to achieve an excellent hardening degree, which may be a treatment at 80 - 150°C for a few minutes or several tens minutes, or at 30 - 50°C for a few days (approximately 1 - 20 days).

Further, a silver halide photographic emulsion layer preferably contains micro-particles having a particle size of approximately 2 - 10 μm to prevent wear of the colloid during printing; such as silica, clay, talc, Zeeklite and rice starch can be utilized, however, silica is specifically preferred. Silica is added in silver halide emulsion so as to make 0.01 - 1 g of silica per 1 m$^2$. When the concentration of silica particles become excessively high, ink density becomes difficult to be increased and scamming phenomena may be caused.

To improve photographic sharpness, finally resolution and sharpness of printed matter, anti-reflection dye or pigment is preferably applied. These are applied in a silver halide emulsion layer, a so-called hydrophilic layer between a support and a silver halide emulsion layer, or in a back-coat layer, whereby the object can be achieved.

On the outer surface of a silver halide emulsion layer, a physical nucleus layer to form an image receiving layer in a silver salt diffusion transfer method is coated. Physical nuclei include metal colloid micro-particles of such as silver, antimony, bismuth, cadmium, cobalt, lead, nickel, palladium, rhodium, gold and platinum; sulfide, polysulfide, selenide and mixtures or mixed crystals thereof. Further, in a physical development nucleus layer, a hydrophilic binder is preferably incorporated at approximately 0.5 - 50 mg/m$^2$. Said binder includes such as starch, dialdehyde starch, carboxymethyl cellulose, gum arabi, sodium arginate, hydroxyethyl cellulose, polystyrene sulfonic acid, copolymer of vinylimidazole with acrylamide described in JP-A No. 53-21602 and copolymer of acrylamide with methylsulfon substituted by guanyl thiourea described in JP-A No. 8-211614. Further, a developing agent such as hydroquinone, methylhydroquinone and catecol and hardeners exemplified above may be incorporated. The pH of said coating solution is set to a weakly acidic or acidic range. Specifically, a range of pH 1.6 - 4.0 is suitable and preferably a range of pH 1.6 - 3.5.

In this invention, in the case of a layer containing silver halide emulsion being provided, a hydrophilic layer is preferably arranged between a support and a silver halide emulsion layer.

A hydrophilic layer will now be explained. A hydrophilic layer is defined as a layer having a low affinity for ink and a high affinity for water when a lithographic plate material is utilized as a printing plate.

In this invention, gelatin is preferably contained as a binder in a hydrophilic layer. The amount of gelatin is generally 0.5 - 5 g/$m^2$ and more preferably 1 - 4g/$m^2$. Preferable gelatin is inert deionized gelatin. A part of gelatin may be appropriately substituted by one type or not less than two types of hydrophilic polymers such as water-soluble gelatin, starch, dextrin, albumin, sodium arginate, hydroxyethyl cellulose, gum arabi, polyvinyl alcohol, polyvinyl pyrrolidone, carboxymethyl cellulose, polyacrylamide, styrene-maleic acid anhydride copolymer and polyvinyl methyl ether-maleic acid anhydride copolymer. Further, vinyl polymer water-based dispersion (latex) may be added in a gelatin layer. These binders are preferably hardened with a hardener. A utilized hardener is preferably the aforesaid vinylsulfon compound. A hydrophilic layer preferably contains pigment or dye such as carbon black generally for the purpose of anti-halation.
In this invention, solid powder (such as silica particles) having a mean particle size of 1 - 10 μm may be incorporated in a hydrophilic layer to improve printing adaptability. Further, photographic additives such as a developing agent can be also incorporated, and an under-coat layer may be those described in JP-A Nos. 48-5503, 48-100203 and 49-16507.
In each coated layer such as a hydrophilic layer, a layer containing silver halide emulsion and a physical development nucleus layer, some of anionic, cationic or neutral surfactants may be incorporated and also such as an antifogant, a matting agent, a viscosity increasing agent and an antistatic agent may be incorporated.
A printing plate material manufactured in the above described manner is cut into a desired size, followed by being wound and packed in a roll form to be stored until exposure described later. It is preferable to wind the material in a roll form around a core member having a diameter of 4 - 10 cm.
At this time, to stand against a long term storage, it is preferable to utilize a packaging material provided with an oxygen permeability of not more than $5 \times 10^{-6}$ ml/Pa-$m^2$·30 °C·day, which is described in JP-A No. 2000-206653.
Further, as another preferred embodiment, it is preferable to utilize a packaging material provided with a water permeability of not more than $10^{-6}$ g/Pa·$m^2$·25 °C-day, which is described in JP-A No. 2000-206653.
In a developing solution utilized for a printing plate material provided with a layer containing a silver halide emulsion, incorporated can be an alkaline substance such as sodium hydroxide, potassium hydroxide, lithium hydroxide, sodium tertiary phosphate; a preservative such as sulfite; a silver halide solvent such as thiosulfate, thiocyanate, cyclic imide, 2-mercapto benzoic acid and amine; a thickener such as hydroxymethyl cellulose and carboxymethyl cellulose; an antifoggant such as potassium bromide and compounds described in JP-A 47-26201; a developer such as hydroquinones, catecol and 1-phenyl-3-pyrazolidone; a development modifier such as a polyoxyalkylene compound and an onium compound. Further, in a developing solution, utilized can be a compound to improve ink affinity of the surface silver layer such as described in USP No. 3,776,728.
The surface silver layer of a printing plate material after development can be converted to have ink affinity or be strengthened in ink affinity by use of a surface treatment agent well known in the art.
Such a treatment solution is described in such as Examined Japanese Patent Application Publication No. 48-29723 and USP No. 3,721,559.
In a printing method of this invention, such as a lithographic machine, a desensitization solution and a moisture providing solution, which are generally utilized, can be employed.
In the case of color printing in this invention, a printing plate is preferably provided with small holes for positioning, so-called pin holes, in advance, and is mounted on a printing machine based on these pin holes as a standard. Thereby, the position of a printing plate is kept constant at the time of color printing such as four-colored printing, and doubling is barely caused. Pin holes may have various shapes depending on types of a printing machine; however, a shape of a typical positioning pin hole includes pin holes for printing comprising two types, a U-shaped pin hole and a rectangular pin hole.

## EXAMPLES

In the following, this invention will be specifically explained with reference to examples; however, this invention is not limited thereto. Herein, "part(s)" represents "weight part(s)", unless otherwise mentioned.

Example 1

<Preparation of Support>

Polyethylene terephthalate having IV (intrinsic viscosity) = 0.66 (measured in phenol/tetrachlorethane = 6/4 (weight ratio) at 25°C) was prepared by a conventional method utilizing terephthalic acid and ethylene glycol.
This was palletized and dried at 130°C for 4 hours, being extruded through a T type die after having been fused at 300 °C, followed by being rapidly cooled on a cooling drum of 50 °C, whereby an non-stretched film having a mean layer thickness after thermal fixing of 190 μm.
This was longitudinally stretched by 1.3 times in pre-stage stretching and 2.6 times at a post-stage stretching

at 110 °C.

Next, the film was laterally stretched by use of tenter at 120 °C by 4.5 times. Thereafter, the film was relaxed in the lateral direction at the same temperature by 4% after having been thermally fixed at 240 °C for 20 seconds. Then, the portion chucked by a tenter was slit, and the both edges were subjected to a knurling treatment, followed by being cooled to 40 °C to be wound at 4.8 kg/m.

The width (casting width) of polyethylene terephthalate film prepared in this manner was 2.5 m. The thickness distribution of the obtained support obtained was 3%.

<Preparation of Under-coated Support>

The both surfaces of the above-obtained support film were subjected to a corona discharge treatment of 8 $W/m^2 \cdot min$. Successively one surface being coated with under-coat coating solution "a" to make a dry layer thickness of 0.8 μm, followed by being coated with under-coat coating solution "b" to make a dry layer thickness of 0.1 μm while being subjected to a corona discharge treatment, and each coated layer was dried at 180 °C for 4 minutes (under-coated surface A).

Further, the opposite surface was coated with following under-coat coating solution c-1, c-2, c-3 or c-4 as described in table 1 so as to make a dry layer thickness of 0.8 μm, followed by being coated with the following under-coat coating solution d-1, d-2, d-3 or d-4 as described in table 1 so as to make a dry layer thickness of 1.0 μm, and each coated layer was dried at 180°C for 4 minutes (under-coated surface B).

Successively, each under-coat layer surface was subjected to a plasma treatment under the following plasma treatment condition, followed by further being subjected to the thermal treatment described below.

<Under-coat Coating Solution a>

| | |
|---|---|
| Three dimensional copolymer latex of styrene/glycidyl methacrylate/butyl acrylate = 60/39/1 (Tg = 75°C) (based on solid) | 6.3 parts |
| Three dimensional copolymer latex of styrene/glycidyl methacrylate/butyl acrylate = 20/40/40 | 1.6 parts |
| Anionic surfactant S-1 | 0.1 part |
| Water | 92 parts |

<Under-coat Coating Solution b>

| | |
|---|---|
| Gelatin | 1 part |
| Anionic surfactant S-1 | 0.05 parts |
| Hardener H-1 | 0.02 parts |
| Matting agent (silica, mean particle size of 3.5 μm) | 0.02 parts |
| Anti-mold agent F-1 | 0.01 part |
| Water | 98.9 parts |

[Chemical Structure 1]

S-1

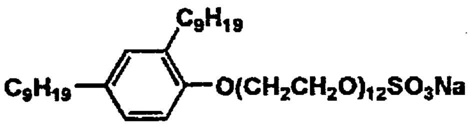

H-1

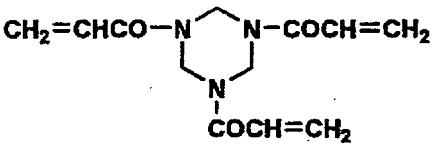

F-1

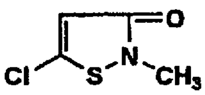

(Component A)

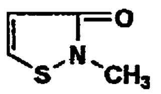

(component B)

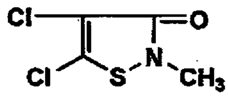

(component C)

Component A/component B/component C = 50/46/4 (mol ratio)

<Under-coat Coating Solution c-1>

| | |
|---|---|
| Three dimensional copolymer latex of styrene/glycidyl methacrylate/butyl acrylate = 20/40/40 (based on solid) | 0.4 parts |
| Four dimensional copolymer latex of styrene/glycidyl methacrylate/butyl acrylate/acetoacetoxyethyl methacrylate = 39/40/20/1 | 7.6 parts |
| Anionic surfactant S-1 | 0.1 part |
| Water | 91.9 parts |

<Under-coat Coating Solution d-1>

| | |
|---|---|
| Conductive composition of component d-11/component d-12/component d-13 = 66/31/1 | 6.4 parts |
| Hardener H-2 | 0.7 parts |
| Anionic surfactant S-1 | 0.07 parts |
| Matting agent (silica, mean particle size of 3.5 μm) | 0.03 parts |
| Water | 92.8 parts |

Component 11: anionic polymer compound comprising copolymer of sodium styrenesulfonate/maleic acid = 50/50

Component 12: three dimensional copolymer latex of styrene/glycidyl methacrylate/butyl acrylate = 40/40/20 Component 13: polymer surfactant comprising styrene/sodium isoprenesulfonate = 80/20

[Chemical Structure 2]

H-2;

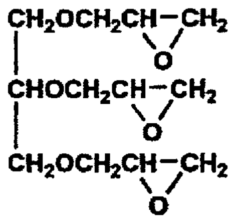

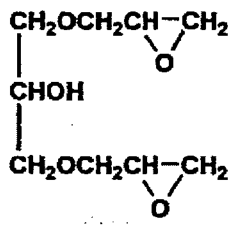

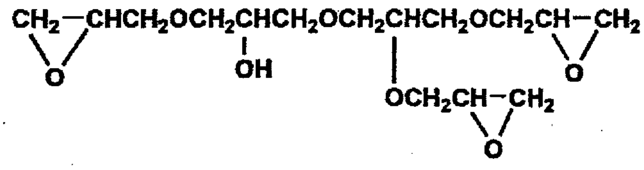

a mixture of three types of

<Under-coat Coating Solution c-2>

| | |
|---|---|
| Jurymer ET-410 (Tg = 52°C, manufactured by Nippon Junyaku Co., Ltd.) | 21 parts |
| $SnO_2$/Sb (9/1 weight ratio, mean particle size of 0.25 μm) | 65 parts |
| Carbon black (SD-10M, mean particle size of 0.2 μm, manufactured by Dainippon Ink & Chemicals Inc.) | 4 parts |
| Matting agent (polymethyl methacrylate, mean particle size of 5 μm) | 4 parts |
| Denacol EX-614B (Nagase ChemteX Corp.) | 6 parts |

<Under-coat Coating Solution d-2>

| | |
|---|---|
| PVdC polymer latex: core portion 90 weight%, shell portion 10 weight% (core-shell type latex), core portion: vinylidene chloride/methyl acrylate/methyl methacrylate/acrylonitrile/acrylic acid = 93/3/3/0.9/0.1 (weight%), shell portion: vinylidene chloride/methyl acrylate/methyl methacrylate/acrylonitrile/acrylic acid = 88/3/3/3/3 (weight%), (weight average molecular weight of 38,000) | 3,000 parts |
| 2,4-dichloro-6-hydroxy-s-triazine | 23 parts |
| Matting agent (polystyrene, mean particle size of 2.4 μm) | 1.5 parts |

<Under-coat Coating Solution c-3>

| | |
|---|---|
| Three dimensional copolymer latex of styrene/glycidyl methacrylate/butyl acrylate = 60/39/1 (Tg = 75°C) (based on solid) | 6.2 parts |
| Three dimensional copolymer latex of styrene/glycidyl methacrylate/butyl acrylate 20/40/40 | 1.7 parts |
| Anionic surfactant S-1 | 0.1 part |
| Water | 92.0 parts |

<Under-coat Coating Solution d-3>

| | |
|---|---|
| Gelatin | 1 part |
| Anionic surfactant S-1 | 0.05 parts |
| Anti-mold agent F-1 | 0.01 part |
| Water | 98.9 parts |

<Under-coat Coating Solution c-4>

| | |
|---|---|
| Three dimensional copolymer latex of styrene/glycidyl methacrylate/butyl acrylate 20/40/40 (based on solid) | 0.4 parts |
| Four dimensional copolymer latex of styrene/glycidyl methacrylate/butyl acrylate/acetoacetoxyethyl methacrylate = 39/40/20/1 | 7.6 parts |
| Anionic surfactant S-1 | 0.1 part |
| Water | 91.9 parts |

<Under-coat Coating Solution d-4>

| | |
|---|---|
| Conductive composition of component d-11/component d-12/component d-13 = 66/31/1 | 3.2 parts |
| Hardener H-2 | 0.7 parts |
| Anionic surfactant S-1 | 0.06 parts |
| Matting agent (silica, mean particle size of 5 μm) | 0.04 parts |
| Water | 96.0 parts |

Component 11: anionic polymer compound comprising copolymer of sodium styrenesulfonate/maleic acid = 50/50

Component 12: three dimensional copolymer latex of styrene/glycidyl methacrylate/butyl acrylate 40/40/20 Component 13: polymer surfactant comprising styrene/sodium isoprenesulfonate 80/20

<Plasma Treatment Condition>

Plasma treatment was performed at a high frequency power of 4.5 kW, a frequency of 5 kHz, and a treatment time of 5 seconds and in argon, nitrogen and hydrogen with a volume ratio of 90%, 5% and 5% respectively as a gas condition, by use of Atmospheric Plasma Treatment Apparatus of a batch type (AP-I-H-340, produced by E. C. Chemical Co., Ltd.).

<Thermal Treatment Condition>

A low tension thermal treatment was performed against the above-described under-coated support after having been slit into 1.25 m width at a tension of 2 hPa and 180 °C for 1 minute.

<Preparation of Printing Plate Material>

(Preparation of Silver Halide Emulsion A)

Silver chlorobromide core emulsion, a mean diameter of which was 0.09 μm, having a silver chloride content of 70% and comprising silver bromide for the rest, was prepared by employing a double-jet method. At the time of precipitation of the core grains, a silver nitrate solution and a water-soluble halide solution were simultaneously mixed, while keeping a pH of 3.0 and a silver potential (EAg) of 165 mV in the presence of 7 x $10^{-8}$ mol of $K_3Rh(NO)_4(H_2O)_2$

and 8 x $10^{-6}$ mol of $K_3OsCl_6$, per 1 mol of silver at the finish of core grain formation.

This core grain, EAg of which was lowered to 125 mV with common salt, was covered with a shell by employing a double-jet method. At that time, $3 \times 10^{-7}$ mol of $K_2IrCl_6$ and $9 \times 10^{-8}$ mol of $K_3RhCl_6$, per 1 mol of silver, were added into a halide solution. Further, KI conversion was performed by employing silver iodide micro-grains.

Prepared silver halide emulsion A was core/shell type monodispersed (coefficient of variation of 10%) silver chloroiodobromide (comprising silver chloride at a content of 85 mol%, silver iodobromide at a content of 0.1 mol% and silver bromide for the rest) cubic emulsion having a mean diameter of 0.2 μm and a [100] plane ratio of 87%.

Next, the emulsion was desalted by use of example compound (G-8) of modified gelatin described in p.3 of JP-A No. 2-280139. The EAg after desalting was 190 mV at 50 °C.

Further, the emulsion was spectrally sensitized with sensitizing dye A after having been chemically sensitized with chloroauric acid, inorganic sulfur, thiourea dioxide and 2,3,4,5,6-pentafluorophenyl phosphinselenide.

[Chemical Structure 3]

Sensitizing dye A

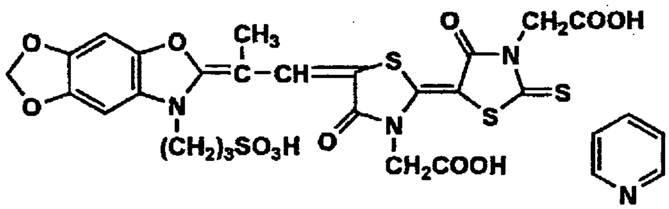

(Preparation of Coating Solution)

<Hydrophilic Layer Coating Solution>

| | |
|---|---|
| Gelatin | 21 parts |
| Silica micro-particles (particle size of 3 μm) | 9 parts |
| Carbon black dispersion (solid content of 32 weight %) | 8 parts |
| Styrene-butadiene latex (POL 752A, manufactured by Nippon A & L Co., Ltd.) | 2 parts |
| Surfactant; sodium dodecylbenzene sulfonate | 0.2 parts |
| Vinylsulfone compound HD-2 | 2 parts |

The total volume was made up to 400 parts and the pH was adjusted to 5. The wet coating amount was 40 g/m$^2$.
HD-2: $CH_2CHSO_2CH_2CH_2SO_2CHCH_2$

<Silver Halide Emulsion Layer Coating Solution>

| | |
|---|---|
| Silver halide emulsion A (silver nitrate/gelatin weight ratio = 2/1) | 14 parts based on silver nitrate |
| 1-phenyl-3-pyrazolidone | 1 part |
| Surfactant; sodium dodecylbenzene sulfonate | 0.2 parts |

The total volume was made up to 120 parts and the pH was adjusted to 4.5. The wet coating amount was 12 g/m$^2$.

(Preparation of Palladium Sulfide Sol)

A solution

| | |
|---|---|
| Palladium chloride | 5 g |
| 12 M hydrochloric acid | 40 ml |
| Distilled water | 1000 ml |

B solution

| | |
|---|---|
| Soda sulfide | 8.6 g |
| Distilled water | 1000 ml |

A solution and B solution were mixed while stirring, and after 30 minutes, the mixture was passed through a column filled with ion exchange resin to prepare palladium sulfide sol.

<Physical Development Nucleus Layer Coating Solution>

| | |
|---|---|
| The above-described palladium sulfide sol | 10 parts |
| Hydroquinone | 6 parts |
| 1-phenyl-3-pyrazolidone | 0.4 parts |
| Polymer (copolymer of acrylamide(97) with vinylimidazole (3); mean molecular weight of 100,000) | 0.05 parts |
| Surfactant; sodium dodecylbenzene sulfonate | 0.02 parts |
| Vinylsulfone compound HD-2 | 2 parts |

The total volume was made up to 100 parts and the pH was adjusted to 2.8. The wet coating amount was 10 $g/m^2$.

<Back-coat Layer Coating Solution>

| | |
|---|---|
| Titanium White | 0.5 $g/m^2$ |
| Polymethyl methacrylate particles (spherical, mean particle size of 5 μm) | 0.2 $g/m^2$ |
| Gelatin | 2 $g/m^2$ |
| Vinylsulfone compound HD-3 | 0.1 $g/m^2$ |
| HD-3: $CH_2CHS0_2CH_2CH_2CH_2SO_2CHCH_2$ | |

[Preparation of Lithographic Plate Material]

On the B surface of a support having been coated with an under-coat layer, the above-described back-coat layer coating solution was coated by a slide-hopper coating method and dried under following condition A.

Herein, the drying process is divided into 5 zones and temperature, humidity and retention time at each zone are controllable. The first zone was set to 0 °C and utilized for cooling and set. The second and third zones were utilized as a constant rate drying stage, in which the web was dried at the maximum web temperature (the surface temperature of the emulsion layer) of 14 °C.

Condition A: After a constant rate drying, the web temperature was raised to 50°C in the fourth zone, and to 55 °C in the fifth zone. After a constant rate drying, the web was dried by having been kept for 15 seconds as a retention time.

Next, on each A surface of a support having been under-coated, the above-described hydrophilic layer coating solution and silver halide emulsion coating solution were simultaneously multi-layer coated by a slide-hopper coating method and dried. The drying process was divided into 5 zones and each was controllable with respect to temperature and humidity. The first zone was set to 0 °C and utilized for cooling and set. The second and third zones were utilized as a constant rate drying stage, in which the web was dried at the maximum web temperature (the surface temperature of the emulsion layer) of 14 °C. The web temperature was raised to 30 °C in the fourth zone, and to 40 °C in the fifth zone. The web retention time was 10 seconds in the fifth zone. Successively, a physical development nucleus layer coating solution was coated by a dip/wire bar squeeze method, and dried with a 30°C wind to prepare lithographic plate materials 101 - 104.

[Measurement of Each Characteristic]

Each characteristic of the above-prepared each lithographic plate material was measured according to the following method.

<Measurement of Surface Specific Resistance>

Apparatus: Teraohm Meter Model VE-30, produced by Kawaguchi Electric Works Co., Ltd.

Method: after the sample was kept under a condition of 23 °C and 20% RH for 24 hours, the surface specific resistance of the back-coat layer side of the above-prepared lithographic plate material was measured in a similar environment.

[Image Forming by Red Semiconductor Laser and Preparation of Printing Plate Sample]

The above-described lithographic plate material was cut to fit an exposure size and exposed by use of Dolev 800V3 (produced by Scitex Ltd., Corp.). In exposure, a laser beam having a wavelength of 650 nm and a spot diameter of 18 μm was utilized to form an image at 175 lines per 2,54 cm (175 lines per inch), and development at 38°C for 15 seconds was further performed by an automatic developer CP-286S (manufactured by Mitsubishi Paper Co., Ltd./ Dainippon Screen Co., Ltd.), a neutralization process at 38°C for 15 seconds being performed, followed by being dried at 45 °C, whereby a printing plate material was prepared.

Herein, developing solutions A, B and a solution for neutralization and ink affinity, which have been prepared in the following manner, were utilized.

(Developing Solution A)

| | |
|---|---|
| EDTA-2Na | 1 g |
| Potassium hydroxide | 20 g |
| Sodium sulfite anhydride | 50 g |
| 2-mercapto benzoic acid | 1.5 g |
| 2-aminoethyl-aminoethanol | 15 g |
| Hydrophobing agent: 2-mercapto-5-n-heptyloxadiazole | 0.25 g |
| Hydroxyphenyl stearate (Nova Acid P, manufactured by Nippon Oil & Fatt Corp.) | 1 g |
| Water to make the total volume of 1 L | |

<Solution for Neutralization and Ink Affinity>

| | |
|---|---|
| Phosphoric acid | 1.2 g |
| Sodium primary phosphate | 25 g |
| Sodium sulfite anhydride | 2.5 g |
| Ethylene glycol | 5 g |
| Hydrophobing agent: 2-mercapto-5-n-heptyloxadiazole | 0.1 g |
| Diethanolamine | 5 g |

Water is added to make the total volume of 1 L. The pH is adjusted to 6.

The above-described printing plate sample was cut in a size of 73 cm wide and 32 cm long and wound around a core made of a cardboard to prepare a printing plate sample of a roll form. Further, the sample was wrapped with a packaging material of 150 cm x 2 m made of a material comprising $Al_2O_3$PET (12μm)/Ny (15μm)/CPP (70μm) .

The printing plate sample having been packaged was heated at 50°C and 60% relative humidity for 7 days as an accelerated aging condition.

The oxygen permeability of the packaging material was 1.7 x $10^{-5}$ ml/Pa·$m^2$·30°C·day and the moisture permeability was 1.8 x $10^{-5}$ g/Pa·$m^2$·25°C·day.

<Preparation of Sheet Material U-1>

Polyethylene terephthalate having an IV (intrinsic viscosity) of 0.66 (measured in phenol/tetrachloroethane = 6/4 at 25 °C) was prepared by use of terephthalic acid and ethylene glycol according to a conventional method.

This was dried at 130 °C for 4 hours after having been palletized, and then extruded from a T-type die after having been fused at 300°C, whereby non-stretched film having a mean layer thickness after thermal fixing of 50 μm was prepared. This film was subjected to longitudinal stretching of a pre-stage stretching at 102 °C by 1.3 times and a post-stage stretching at 110 °C by 2.6 times.

Next, the film was stretched in the lateral direction at 120 °C by 4.5 times by use of a tenter. Thereafter, the film was thermally fixed at 240 °C for 20 seconds followed by being relaxed in the lateral direction at the same temperature by 4%. Thereafter, after the chucked portion of a tenter was slit, the both edges of the film were subjected to a knurling treatment and the film was cooled to 40 °C to be wound at 4.8 kg/m. In this manner, polyethylene terephthalate film was prepared. The thickness distribution of the prepared support was 7%.

The both sides of the above-obtained support film were subjected to a corona discharge treatment of 8W/$m^2$, and successively, one surface (A surface) being coated with coating solution c-11 described below so as to make a dry layer thickness of 0.7 μm, followed by being coated with coating solution d-11 described below so as to make a dry layer thickness of 0.6 μm while being subjected to a corona discharge treatment (8W/$m^2$), and each coated layer was dried at 180 °C for 4 minutes to prepare sheet U-1.

[Coating Solution c-11]

| | |
|---|---|
| Three dimensional copolymer latex of styrene/glycidyl methacrylate/butyl acrylate = 60/39/1 (Tg = 75°C) (based on solid) | 6.2 parts |
| Three dimensional copolymer latex of styrene/glycidyl methacrylate/butyl acrylate = 20/40/40 | 1.7 parts |
| Anionic surfactant S-1 | 0.1 part |
| Water | 92.0 parts |

<Coating Solution d-11>

| | |
|---|---|
| Gelatin | 1 part |
| Anionic surfactant S-1 | 0.05 parts |
| Anti-mold agent F-1 | 0.01 part |
| Water | 98.9 parts |

<Preparation of Sheet Material U-2>

The sheet material U-2 was prepared in a similar manner to preparation of sheet material U-1, except that coating solution c-12 instead of c-11 and coating solution d-12 instead of d-11 were utilized.

<Coating Solution c-12>

| | |
|---|---|
| Three dimensional copolymer latex of styrene/glycidyl methacrylate/butyl acrylate 20/40/40 (based on solid) | 0.4 parts |
| Four dimensional copolymer latex of styrene/glycidyl methacrylate/butyl acrylate/acetoacetoxyethyl methacrylate = 39/40/20/1 | 7.6 parts |
| Anionic surfactant S-1 | 0.1 part |
| Water | 91.9 parts |

<Coating Solution d-12>

| | |
|---|---|
| Conductive composition of component d-11/component d-12/component d-13 = 65/31/1 | 6.4 parts |
| Hardener H-2 | 0.7 parts |
| Anionic surfactant S-1 | 0.07 parts |
| Matting agent (silica, mean particle size of 8 μm) | 0.13 parts |
| Water | 92.7 parts |

Component 11: anionic polymer compound comprising copolymer of sodium styrenesulfonate/maleic acid = 50/50

Component 12: three dimensional copolymer latex of styrene/glycidyl methacrylate/butyl acrylate = 40/40/20

Component 13: polymer surfactant comprising styrene/sodium isoprenesulfonate = 80/20

<Preparation of Sheet Material U-3>

The sheet material U-3 was prepared in a similar manner to preparation of sheet material U-1, except that coating solution c-13 instead of c-11 and coating solution d-13 instead of d-11 were utilized.

<Coating Solution c-13>

| | |
|---|---|
| Jurymer ET-410 (Tg = 52 °C, manufactured by Nippon Junyaku Co., Ltd.) | 21 parts |
| $SnO_2$/Sb (9/1 weight ratio, mean particle size of 0.25 μm) | 67 parts |
| Matting agent (polymethyl methacrylate, mean particle size of 5 μm) | 4 parts |
| Denacol EX-614B (Nagase ChemteX Corp.) | 7 parts |

<Coating Solution d-13>

| | |
|---|---|
| PVdC polymer latex: core portion 90 weigt%, shell portion 10 weight% (core-shell type latex), core portion: vinylidene chloride/methyl acrylate/methyl methacrylate/acrylonitrile/acrylic acid = 93/3/3/0.9/0.1 (weight%), shell portion: vinylidene chloride/methyl acrylate/methyl methacrylate/acrylonitrile/acrylic acid = 88/3/3/3/3 (weight%), (weight average molecular weight of 38000) | 3000 parts |
| 2,4-dichloro-6-hydroxy-s-triazine | 23 parts |
| Matting agent (polystyrene, mean particle size of 4.5 μm) | 2 parts |

The surface specific resistance was measured according to the following method.

<Preparation of Sheet Material U-4>

The sheet material U-4 was prepared in a similar manner to preparation of sheet material U-1, except that

coating solution c-14 instead of c-11 and coating solution d-14 instead of d-11 were utilized.

<Coating Solution c-14>

| | |
|---|---|
| Three dimensional copolymer latex of styrene/glycidyl methacrylate/butyl acrylate = 20/40/40 (based on solid) | 0.4 parts |
| Four dimensional copolymer latex of styrene/glycidyl methacrylate/butyl acrylate/acetoacetoxyethyl methacrylate = 39/40/20/1 | 7.6 parts |
| Anionic surfactant S-1 | 0.1 part |
| Water | 91.9 parts |

<Coating Solution d-14>

| | |
|---|---|
| Conductive composition of component d-11/component d-12/component d-13 = 66/31/1 | 1.2 parts |
| Hardener H-2 | 0.7 parts |
| Anionic surfactant S-1 | 0.05 parts |
| Matting agent (silica, mean particle size of 4 μm) | 0.08 parts |
| Water | 98.0 parts |

Component 11: anionic polymer compound comprising copolymer of sodium styrenesulfonate/maleic acid = 50/50

Component 12: three dimensional copolymer latex of styrene/glycidyl methacrylate/butyl acrylate = 40/40/20

Component 13: polymer surfactant comprising styrene/sodium isoprenesulfonate = 80/20

Herein, center-line mean roughness Ra of the surface in contact with aforesaid sheet materials U-1 - U-4 were as follows: 0.07 μm for U-1, 2.02 μm for U-2, 1.01 μm for U-3 and 0.32 μm for U-4.

<Measurement of Surface Specific Resistance>

Apparatus: Teraohm Meter Model VE-30, produced by Kawaguchi Electric Works Co., Ltd.

Method: after the sample was kept under a condition of 23 °C and 20% RH for 24 hours, the surface specific resistance of the opposite surface of A surface of the above prepared sheet materials was measured in a similar environment.

(Evaluation of Various Characteristics as Printing Plate)

With respect to the printing plate samples prepared in the above manner, printing was performed in combination with sheet materials, which are described in table 1, according to the following printing method and various characteristics as a printing plate were evaluated.

<Printing Method>

Lithrone 26 (4 colored machine) produced by Komori Corporation was utilized as a printing machine, and the prepared sheet was cut into a predetermined size and adhered onto a plate drum so as to make the A surface side on the plate drum side of the printing machine. Printing was performed by utilizing coated paper, a 2 weight% solution of Astromark 3 (manufactured by Nikken Chemical laboratory Ltd.) as a dampening solution and New Champion Naturalith SP8 magenta N (manufactured by Dainippon Ink & Chemicals Inc.) as ink. As sequence of the print start, printing sequence of a PS plate was employed.

<Evaluation of Initial Ink Receptivity>

Printing on coated paper was performed by mounting the printing plate prepared above on the aforesaid printing machine and by employing the aforesaid dampening solution and ink. Sequence of a PS plate was applied as the

sequence of print start, and evaluation was made with respect how many sheets were required before ink adhesion on the non-image portion goes off. The smaller is the number of sheets, the more excellent is ink receptivity.

<Evaluation of Printing Durability>

Printing on the back surface of wood free paper, the front surface of which had been printed, was performed by mounting the exposed printing plate sample on the aforesaid printing machine and utilizing the aforesaid dampening solution and ink, while spraying NIKKALYCO AS-160 (mean particle size of 20 - 30 μm, manufactured by Nikka Co., Ltd.) as powder.

Printing was performed up to 30,000 sheets. The number of sheet printed, at which not less than half of the dots in a 3% halftone image were missing, was determined as a printing durability sheet number. The larger is the number of sheet printed, the more excellent is printing durability.

<Evaluation of Image Quality>

After 5,000 sheets printing, quality of a 2% halftone image was visually observed through a 100 magnification loupe and the quality was ranked into 5 steps. Rank 5 represents high quality halftone without fringes, and the rank was lowered as the quality deteriorates. Ranks less than rank 3 represent unusable image quality.

<Evaluation of Print Position Stability>

Flaw having a width of 50 μm was marked on the plate surface at 2 portions separating by 50 cm. Four of these plates were prepared and printing was performed. Herein, printing was performed by utilizing New Champion Naturalith SP8 yellow N, magenta N, cyan N and black N as four color ink.

After confirming the four colors of a cross image on the 100th sheet, consecutive 2,000 sheets were printed. How much the doubling of each color of a cross on the printed paper surface generated at the finish of 2,000 sheets printing, was measured by use of a loupe. The smaller is the value, the more excellent is position stability.

The results obtained above are shown in table 1.

It is clear from table 1 that a printing method of this invention is superior in print position stability, as well as excellent in initial ink receptivity, printing durability and image quality.

Table 1

| *1 | Under-cost layer recipe for back-coat layer | Surface specific resistance of back-coat layer | *2 | Surface specific resistance of sheet | *3 | Printing durability (number sheets) | Image quality (rank) | Printing position of stability (μm) | Remarks |
|---|---|---|---|---|---|---|---|---|---|
| 103 | c-3/d-3 | 5 x $10^{14}$ Ω | U-1 | 5 x $10^{16}$ Ω | 180 | 1800 | 2 | 350 | Comparison |
| 103 | c-3/d-3 | 5 x $10^{14}$ Ω | U-2 | 2 x $10^{10}$ Ω | 150 | 1500 | 2 | 300 | Comparison |
| 101 | c-1/d-1 | 4 x $10^{10}$ Ω | U-1 | 5 x $10^{16}$ Ω | 170 | 2000 | 2 | 250 | Comparison |
| 101 | c-1/d-1 | 4 x $10^{10}$ Ω | U-2 | 2 x $10^{10}$ Ω | 15 | 30000 | 5 | 25 | Invention |
| 102 | c-2/d-2 | 1 x $10^{9}$ Ω | U-2 | 2 x $10^{10}$ Ω | 15 | 30000 | 5 | 20 | Invention |
| 104 | c-4/d-4 | 2 x $10^{13}$ Ω | U-3 | 1 x $10^{8}$ Ω | 20 | 20000 | 5 | 25 | Invention |
| 104 | c-4/d-4 | 2 x $10^{13}$ Ω | U-4 | 2 x $10^{15}$ Ω | 25 | 20000 | 5 | 30 | Invention |
| 102 | c-2/d-2 | 1 x $10^{9}$ Ω | U-4 | 2 x $10^{15}$ Ω | 20 | 20000 | 5 | 25 | Invention |

*1: Planographic plate material
*2: sheet material
*3: Initial ink receptivity (number of sheets)

## Claims

**1.** A mounting method of mounting a printing plate material on a printing machine, comprising the steps of:

mounting an underlay sheet material on a plate drum of a printing machine; and
further mounting a printing plate material on the underlay sheet material;

wherein the printing plate material comprises a plastic support and has a hydrophilic layer and an image forming functional layer on one surface of the plastic support and a back-coat layer on the other side of the plastic support; **characterized in that** the surface specific resistance of the back-coat layer side of said printing plate material is $1 \times 10^9$ - $2 \times 10^{13}$ Ω and the surface specific resistance of the surface, which is in contact with the back-coat layer of the printing plate material, of said underlay sheet material is $1 \times 10^8$ - $2 \times 10^{15}$ Ω, wherein the surface specific resistance is measured at 23°C and a relative humidity of 20%.

2. The mounting method according to claim 1, wherein the thickness of the underlay sheet material is 30 - 250 μm.

3. The mounting method according to claim 1 or 2, wherein the plastic support is a polyester film support having a thickness of 120 - 300 μm and a thickness distribution of 10% or less.

4. The mounting method according to anyone of claims 1 to 3, wherein a layer containing a silver halide emulsion is provided on the hydrophilic layer of the printing plate material.

5. A printing method which uses a printing plate material mounted on a plate drum of a printing machine as defined in any one of claims 1 to 4.

## Patentansprüche

1. Aufziehverfahren zum Aufziehen eines Druckplattenmaterials auf eine Druckmaschine, das die Stufen:

Aufziehen eines Unterlagenmaterials auf einen Plattenzylinder einer Druckmaschine und
ferner Aufziehen eines Druckplattenmaterials auf das Unterlagenmaterial umfasst;

wobei das Druckplattenmaterial ein Kunststoffträgermaterial umfasst und eine hydrophile Schicht und eine Bilderzeugungsfunktionsschicht auf einer Oberfläche des Kunststoffträgermaterials und eine Rückschicht auf der anderen Seite des Kunststoffträgermaterials aufweist;
**dadurch gekennzeichnet, dass** der spezifische Oberflächenwiderstand der Rückschichtseite des Druckplattenmaterials $1 \times 10^9$ - $2 \times 10^{13}$ Ω beträgt und der spezifische Oberflächenwiderstand der Oberfläche des Unterlagenmaterials, die mit der Rückschicht des Druckplattenmaterials in Kontakt steht, $1 \times 10^8$ - $2 \times 10^{15}$ Ω beträgt, wobei der spezifische Oberflächenwiderstand bei 23°C und einer relativen Feuchtigkeit von 20 % gemessen wird.

2. Aufziehverfahren nach Anspruch 1, wobei die Dicke des Unterlagenmaterials 30 - 250 μm beträgt.

3. Aufziehverfahren nach Anspruch 1 oder 2, wobei das Kunststoffträgermaterial ein Polyesterfilmträgermaterial mit einer Dicke von 120 - 300 μm und einer Dickenverteilung von 10 % oder weniger ist.

4. Aufziehverfahren nach einem der Ansprüche 1 bis 3, wobei eine eine Silberhalogenidemulsion enthaltende Schicht auf der hydrophilen Schicht des Druckplattenmaterials angebracht ist.

5. Druckverfahren, das ein Druckplattenmaterial verwendet, das auf einen Plattenzylinder einer Druckmaschine gemäß den Angaben in einem der Ansprüche 1 bis 4 aufgezogen ist.

## Revendications

1. Procédé de fixation consistant à fixer un matériau de plaque d'impression sur une machine à imprimer, comprenant les étapes consistant :

à fixer un matériau de sous-couche en feuille sur un tambour à plaque d'une machine à imprimer ; et
à fixer ensuite un matériau de plaque d'impression sur le matériau de sous-couche en feuille ;

dans lequel le matériau de plaque d'impression comprend un support en plastique et a une couche hydrophile et

une couche fonctionnelle formant une image sur une surface du support en plastique et une couche d'enduit de planéité sur l'autre côté du support en plastique ;
**caractérisé en ce que** la résistance spécifique de la surface du côté couche d'enduit de planéité dudit matériau de plaque d'impression est de 1 x $10^9$ à 2 x $10^{13}$ Ω et la résistance spécifique de la surface qui est en contact avec la couche d'enduit de planéité du matériau de plaque d'impression dudit matériau de sous-couche en feuille est de 1 x $10^8$ à 2 x $10^{15}$ Ω, dans lequel la résistance spécifique de la surface est mesurée à 23°C et une humidité relative de 20%.

**2.** Procédé de fixation selon la revendication 1, dans lequel l'épaisseur du matériau de sous-couche en feuille est de 30 à 250 μm.

**3.** Procédé de fixation selon la revendication 1 ou 2, dans lequel le support en plastique est un support de film en polyester ayant une épaisseur de 120 à 300 μm et une distribution d'épaisseur de 10% ou moins.

**4.** Procédé de fixation selon l'une quelconque des revendications 1 à 3, dans lequel une couche contenant une émulsion d'halogénure d'argent est fournie sur la couche hydrophile du matériau de plaque d'impression.

**5.** Procédé d'impression qui utilise un matériau de plaque d'impression fixé sur un tambour à plaque d'une machine à imprimer tel que défini selon l'une quelconque des revendications 1 à 4.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5066564 A
- JP 2001096710 A
- JP 5257287 A
- JP 2000258899 A
- JP 2002079773 A
- JP 10193828 A
- EP 1498281 A
- US 3428451 A
- US 2861056 A
- US 3206312 A
- JP 7020596 A
- JP 56143431 A
- JP 56120519 A
- JP 58062647 A
- US 2322037 A
- BE 625451
- GB 981198 A
- JP 443643 A
- CH 330158
- US 3079257 A
- US 3022169 A
- FR 1296959
- GB 1173181 A
- JP 2805012 B
- JP 2002258469 A
- JP 8507727 PCT
- JP 6186750 A
- JP 9123387 A
- JP 2002361996 A
- JP 4261539 A
- JP 63029603 A
- JP 2306236 A
- JP 3167545 A
- JP 4076534 A
- JP 6110146 A
- JP 5273683 A
- JP 7128768 A
- US 2448060 A
- GB 618061 A
- JP 2000122297 A
- JP 6230577 A
- JP 2001035026 A
- JP 53021602 A
- JP 8211614 A
- JP 48005503 A
- JP 48100203 A
- JP 49016507 A
- JP 2000206653 A
- JP 47026201 A
- US 3776728 A
- JP 48029723 A
- US 3721559 A
- JP 2280139 A

### Non-patent literature cited in the description

- **P. GLAFKIDES.** Chimie et Physique Photographique. Paul Montel Corp, 1967
- **G. F. DUFFIN.** Photographic Emulsion Chemistry. The Focal Press, 1966
- **V. L. ZELIKMAN.** Making and Coating Photographic Emulsion. The Focal Press, 1964
- AP-I-H-340. E. C. Chemical Co., Ltd,